(19) Europäisches Patentamt
European Patent Office
Office européen des brevets

(11) **EP 3 602 089 B1**

(12) **EUROPÄISCHE PATENTSCHRIFT**

(45) Veröffentlichungstag und Bekanntmachung des Hinweises auf die Patenterteilung:
**05.07.2023   Patentblatt 2023/27**

(21) Anmeldenummer: **18714952.1**

(22) Anmeldetag: **15.03.2018**

(51) Internationale Patentklassifikation (IPC):
**G01R 31/08** *(2020.01)*    **G01S 5/18** *(2006.01)*
**G01S 11/16** *(2006.01)*

(52) Gemeinsame Patentklassifikation (CPC):
**G01R 31/083; G01S 11/16;** G01R 31/088;
G01R 31/1209

(86) Internationale Anmeldenummer:
**PCT/AT2018/000014**

(87) Internationale Veröffentlichungsnummer:
**WO 2018/176071 (04.10.2018 Gazette 2018/40)**

(54) **VERFAHREN ZUR FEINORTUNG EINES KABELFEHLERS EINES ERDVERLEGTEN KABELS**

METHOD FOR ACCURATELY LOCATING A CABLE DEFECT OF A CABLE LAID IN THE GROUND

PROCÉDÉ SERVANT À LOCALISER AVEC PRÉCISION UN DÉFAUT DE CÂBLE D'UN CÂBLE ENTERRÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.03.2017   AT 1292017**

(43) Veröffentlichungstag der Anmeldung:
**05.02.2020   Patentblatt 2020/06**

(73) Patentinhaber: **BAUR GmbH**
**6832 Sulz (AT)**

(72) Erfinder:
• **JENNY, Martin**
  **6850 Dornbirn (AT)**
• **BAUR, Martin**
  **6832 Sulz (AT)**
• **HERPERTZ, Peter**
  **6835 Muntlix (AT)**

(74) Vertreter: **Torggler & Hofmann Patentanwälte - Rankweil**
**Torggler & Hofmann Patentanwälte GmbH & Co KG**
**Hörnlingerstraße 3**
**Postfach 5**
**6830 Rankweil (AT)**

(56) Entgegenhaltungen:
DE-A1-102010 013 613    DE-A1-102010 051 213
DE-A1-102012 011 066    US-A1- 2012 105 073

EP 3 602 089 B1

**Beschreibung**

Die Erfindung bezieht sich auf ein Verfahren zur Feinortung eines Kabelfehlers eines erdverlegten Kabels zur Übertragung von elektrischer Energie, bei welchem mit einer mobilen Feinortungseinrichtung auf der Basis einer zuvor durch eine Vorortung ermittelten ungefähren Position des Kabelfehlers eine präzise Position des Kabelfehlers ermittelt wird, wobei mittels der mobilen Feinortungseinrichtung ein Abstand der Fehlerstelle des Kabels von einer aktuellen Position der mobilen Feinortungseinrichtung bestimmt wird, wobei zur Bestimmung des Abstands der Fehlerstelle von der aktuellen Position der mobilen Feinortungseinrichtung Stoßspannungsimpulse in das Kabel eingespeist werden und von der mobilen Feinortungseinrichtung die Zeitdifferenz zwischen einem, von einem der Stoßspannungsimpulse hervorgerufenen, elektromagnetischen Impuls, der mittels eines elektromagnetischen Sensors der Feinortungseinrichtung detektiert wird, und einem durch einen von diesem Stoßspannungsimpuls ausgelösten Überschlag beim Kabelfehler hervorgerufenen akustischen Impuls, der mittels eines Bodenmikrophons detektiert wird, gemessen wird und von der Feinortungseinrichtung aus dieser Zeitdifferenz der Abstand der Fehlerstelle von der aktuellen Position der mobilen Feinortungseinrichtung bestimmt wird.

Bei erdverlegten Kabeln zur Übertragung von elektrischer Energie können Fehler auftreten, welche eine Reparatur des Kabels im Bereich der Fehlerstelle erforderlich machen. Es kann sich hierbei um Nieder-, Mittel- oder Hochspannungskabel handeln. Um die Reparatur durchführen zu können, ist es zunächst erforderlich, den Kabelfehler zu orten. Verfahren sind hierzu bekannt.

Bei bekannten Verfahren zur Ortung von Kabelfehlern erfolgt zunächst eine Vorortung (Grobortung). Ein Beispiel hierfür ist die Sekundär-Mehrfachimpulsmethode, bei welcher es sich um ein Hochspannungs-Messverfahren handelt, welches für hochohmige Kabelfehler geeignet ist. Zur Ortung eines Kabelfehlers werden eine erste Reflektion eines Spannungspulses am Kabelende und eine zweite Reflektion durch einen Überschlag an der Fehlerstelle erfasst. Daneben sind weitere Verfahren zur Vorortung bekannt, z.B. Decay und ICM.

Als Ergebnis einer solchen Vorortung erhält man die Kabellänge zwischen dem Ort der Einspeisung des Vorortungssignals und der Fehlerstelle. Bei bekannter Kabeltrasse (=Verlauf des Kabels im Erdreich) kann damit die Position des Kabelfehlers bestimmt werden. Für die Kabeltrasse stehen entweder Geo-Daten zur Verfügung oder eine Bestimmung der Verlegestrecke des erdverlegten Kabels ist erforderlich. Solche Bestimmungen der Verlegestrecke (=des Kabelverlaufs) werden beispielsweise durch Einspeisen einer Tonfrequenz in das vom Netz getrennte Erdkabel und eine oberirdisch entlang der Kabeltrasse geführte Suchspule durchgeführt.

Allerdings liefern die bekannten Verfahren zur Vorortung nur eine ungefähre Position der Fehlerstelle des Kabels. Ein Grund hierfür ist insbesondere, dass es bei der Verlegung eines Kabels entlang der Kabeltrasse zu mehr oder weniger großen Abweichungen vom kürzesten Verlauf kommt. So kann die Verlegetiefe variieren, es können Kabelschlaufen vorhanden sein, usw. Insgesamt ergibt sich eine Ungenauigkeit der Vorortung des Kabelfehlers, welche meist im Bereich von 1% bis 10% der Länge des Kabels zwischen der Stelle des Einspeisens des Messsignals und dem Kabelfehler beträgt. Je nach Länge dieser Strecke kann somit die Abweichung zwischen der tatsächlichen Position des Kabelfehlers und der durch die Vorortung ermittelten ungefähren Position des Kabelfehlers im Bereich von einigen Metern bis einigen zehn Metern liegen.

Es ist auch bereits bekannt, die ermittelte ungefähre Position des Kabelfehlers auf einer Karte anzuzeigen. Die Vorortung erfolgt mittels einer üblicherweise in einem Messwagen sich befindenden Vorortungseinrichtung, die sich im Bereich einer Kabelstation befindet, von der eine Reihe von Kabeln ausgehen. Deren Verläufe sind als sogenannte "GIS-Daten" bekannt und können in der Vorortungseinrichtung gespeichert sein. Nachdem der Nutzer den Anfang des Kabels eingegeben hat, an welchem die Vorortung erfolgt, kann nach Ermittlung des Abstands des Kabelfehlers eine ungefähre Position des Kabelfehlers in einer auf der Anzeigeeinheit der Vorortungseinrichtung dargestellten Karte angezeigt werden. Die Vorortungseinrichtung kann auch einen GPS-Empfänger aufweisen, sodass auch die Position des Messwagens in der Karte angezeigt werden kann. Daraufhin kann sich die die Fehlerortung durchführende Person mittels Satellitennavigation zur ungefähren Position des Kabelfehlers begeben.

Um dann auf Basis der zuvor durchgeführten Vorortung (Grobortung) eine präzise Position des Kabelfehlers zu ermitteln, damit an dieser Position im späteren Verlauf die Grabarbeiten durchgeführt werden können, ist ein akustisches Feinortungs-Verfahren bekannt. Hierbei werden mittels eines Stoßspannungsgenerators Stoßspannungsimpulse in das Kabel eingespeist. Diese hochenergetischen Impulse verursachen einen sich im Kabel ausbreitenden Spannungsimpuls, der an der Fehlerstelle zu einem Überschlag führt. Dabei wird ein in der Umgebung des Kabelfehlers mit einem Bodenmikrophon detektierbares akustisches Signal erzeugt. Es kann nunmehr mit dem Bodenmikrophon die Stelle der höchsten Amplitude des Durchschlaggeräusches gesucht werden, um die Position des Kabelfehlers zu ermitteln. Bei jeder Messung wird das Bodenmikrophon auf dem Untergrund abgesetzt und auf den nächsten Stoßspannungsimpuls und das hierdurch ausgelöste akustische Signal gewartet. Eine Fehlersuche auf diese Weise ist allerdings sehr zeitaufwendig.

Eine Verbesserung dieses Verfahrens besteht darin, dass ein Abstand der Fehlerstelle des Kabels von der aktuellen Position einer mobilen Feinortungseinrichtung bestimmt wird. Hierzu weist die mobile Feinortungseinrichtung zusätzlich zum Bodenmikrophon, welches zur Detektion des akustischen Signals dient, einen elektromagnetischen Sensor auf, mit dem der über das Kabel übertragene Stoßspannungsimpuls und das hierdurch auftretende elektromagnetische Feld detektiert wird. Zwischen diesem detektierten elektromagnetischen Signal und dem detektierten akustischen Signal liegt eine Zeitdifferenz, welche erfasst wird. Diese Zeitdifferenz entspricht der Zeit, welche der Schall von der Fehlerstelle bis zur mobilen Feinortungseinrichtung benötigt (wobei die Zeit der Ausbreitung des Stoßspannungsimpulses demgegenüber vernachlässigbar ist). Somit kann aus dieser ermittelten Zeitdifferenz ein Abstand der Fehlerstelle von der aktuellen Position der mobilen Feinortungseinrichtung bestimmt werden. Dieser Abstand wird auf einer Anzeige der mobilen Feinortungseinrichtung angezeigt. Die den Kabelfehler ortende Person kann somit bei ihren sich wiederholenden Messungen feststellen, ob sich der Abstand zur Fehlerstelle verringert. Wenn dieser Abstand ein Minimum aufweist, befindet sich die Person direkt über der Fehlerstelle des Kabels. Das Suchen der präzisen Position des Kabelfehlers wird dadurch bedeutend vereinfacht.

Ein akustisches Feinortungs-Verfahren, bei welchem die Zeitdifferenz zwischen dem akustischen Signal und dem Stoßspannungsimpuls ausgewertet wird, um den Abstand zum Kabelfehler zu ermitteln, geht beispielsweise aus der EP 2 405 279 A2 hervor. Es geht in dieser Schrift um ein Verfahren, bei dem auch in sehr lauten Umgebungsbedingungen eine akustische Feinortung durchgeführt werden kann.

Neben Einrichtungen zur Fehlerortung, welche eingesetzt werden, nachdem ein Kabelfehler aufgetreten ist, ist auch ein sogenanntes "Online-Monitoring" zur permanenten Überwachung von Kabeln im Betrieb bekannt. Es werden hierzu fix montierte, stationäre Überwachungseinrichtungen eingesetzt.

Aus der CN 105676074 A ist eine Einrichtung zum Online-Monitoring von in Form von Freileitungen verlegten Hochspannungsleitungen bekannt. Es werden Messeinheiten auf Hochspannungsmasten im Abstand von 5km bis 50km montiert, von denen im Fall eines Überschlags auftretende Wanderwellen detektiert werden. Mittels GPS erfolgt eine Zeitsynchronisation und an einer Basisstation wird die Zeitdifferenz zwischen dem Eintreffen der Wanderwellen ausgewertet, um die Position der Fehlerstelle annähernd zu ermitteln.

Aus der DE 10 2010 051 213 A1 geht ein Verfahren zur Ortung elektrischer Störquellen, insbesondere defekter Hochspannungsisolatoren, hervor. Aus der Zeitdifferenz der Detektion der elektromagnetischen Signale und Schallsignale wird der Abstand der Messeinrichtung von der Störquelle bestimmt. Es ist auch angeführt, dass die Messeinrichtung mit einem GPS-Sensor ausgestattet sein kann, wobei die aktuelle Position der Messeinrichtung in einer Karte auf dem Bildschirm der Messeinrichtung dargestellt werden kann, zusammen mit der ermittelten Entfernung zur Störquelle durch einen Kreis um die Position der Messeinrichtung. Im Weiteren können die Koordinaten der Hochspannungsleitung, der Strommasten und/oder direkt der Hochspannungsisolatoren auf der Karte auf dem Bildschirm dargestellt werden.

Aufgabe der Erfindung ist es bei einem Verfahren zur Feinortung der eingangs genannten Art das Auffinden der präzisen Position des Kabelfehlers weiter zu vereinfachen. Erfindungsgemäß gelingt dies durch ein Verfahren mit den Merkmalen des Anspruchs 1.

Beim Verfahren der Erfindung wird mittels eines GPS-Empfängers der Feinortungseinrichtung die aktuelle Position der Feinortungseinrichtung erfasst. Anhand dieser erfassten aktuellen Position der Feinortungseinrichtung, des ermittelten Abstandes der Fehlerstelle des Kabels von der aktuellen Position der Feinortungseinrichtung sowie des in der Feinortungseinrichtung gespeicherten Verlaufs des Kabels wird zumindest eine mögliche präzise Position des Kabelfehlers bestimmt. Auf einer Anzeige der Feinortungseinrichtung wird in einer auf der Feinortungseinrichtung gespeicherten Karte der Umgebung der ungefähren Position des Kabelfehlers oder in einem von einer Kamera der Feinortungseinrichtung aufgenommen Bild zumindest ein Zielort für die präzise Position des Kabelfehlers angezeigt.

Erfindungsgemäß werden zumindest zwei Messungen an unterschiedlichen aktuellen Positionen der Feinortungseinrichtung durchgeführt. Dadurch wird es ermöglicht, ein eindeutiges Ergebnis für die präzise Position des Kabelfehlers zu erhalten, welche dann als Zielort in der gespeicherten Karte oder im von der Kamera aufgenommen Bild auf der Anzeige der Feinortungseinrichtung angezeigt wird. Durch das erfindungsgemäße Verfahren wird dem Benutzer somit direkt mindestens ein Zielort, vorzugsweise genau ein Zielort, für die präzise Position des Kabelfehlers in der Karte oder im Bild angezeigt, sodass sich dieser ohne Umschweife zu diesem Zielort bewegen kann. Das Auffinden der präzisen Position des Kabelfehlers, um dort Grabungsarbeiten zum Freilegen und Reparieren des Kabels durchzuführen, kann dadurch vereinfacht und beschleunigt werden.

Weitere Vorteile und Einzelheiten der Erfindung werden im Folgenden anhand der beiliegenden Zeichnung erläutert. In dieser zeigen:

     Fig. 1 eine schematische Darstellung der Feinortung;
     Fig. 2 eine Prinzipdarstellung der Feinortungseinrichtung;
     Fig. 3 eine Darstellung zur Veranschaulichung der Ermittlung von möglichen präzisen Positionen des Kabelfehlers;
     Fig. 4 eine Darstellung entsprechend Fig. 3 nach der Durchführung einer zweiten Messung;
     Fig. 5 eine Darstellung der Anzeige der Feinortungseinrichtung;
     Fig. 6 eine Prinzipdarstellung entsprechend Fig. 2 für eine modifizierte Ausführungsform der Erfindung;

Fig. 7 eine Darstellung der Anzeige der Feinortungseinrichtung gemäß dieser modifizierten Ausführungsform der Erfindung.

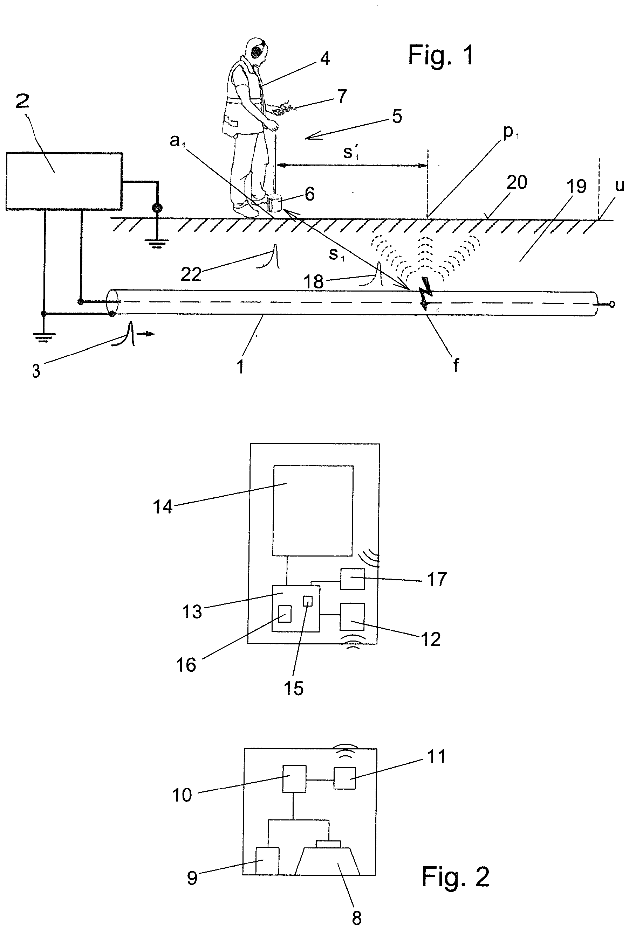

Ein erfindungsgemäßes Verfahren zur Feinortung wird im Folgenden anhand der Figuren beschrieben. Fig. 1 zeigt in schematischer Darstellung ein erdverlegtes Kabel 1 zur Übertragung von elektrischer Energie. Es kann sich um ein Niederspannungskabel (bis 1 kV), ein Mittelspannungskabel (1 kV bis 60 kV) oder ein Hochspannungskabel (> 60 kV, z.B. 110 kV, 220 kV oder 380 kV) handeln. An einer Fehlerstelle f weist das Kabel einen Kabelfehler auf, insbesondere einen hochohmigen Kabelfehler oder einen intermittierenden Kabelfehler. Durch eine bekannte Vorortung (Grobortung) wurde eine ungefähre Position u des Kabelfehlers ermittelt.

Zur Feinortung (=Nachortung) des Kabelfehlers werden mittels eines an das Kabel angeschlossenen Stoßspannungsgenerators 2 Stoßspannungsimpulse 3 in das Kabel 1 eingespeist. Beispielsweise kann alle drei Sekunden die Einspeisung eines Stoßspannungsimpulses erfolgen. Die Abstände zwischen den einzelnen Stoßspannungsimpulsen können auch demgegenüber unterschiedliche Werte aufweisen, vorzugsweise liegen sie aber im Bereich zwischen 1 s und 10 s.

Die Höhe der Stoßspannungsimpulse kann auch von der Art des zu prüfenden Kabels abhängen. Im Allgemeinen wird die Höhe der Stoßspannungsimpulse über 1 kV liegen, beispielsweise bei Niederspannungskabeln im Bereich von 2 bis 5 kV. Bei Mittel- und Hochspannungskabeln wird die Höhe der Spannungsimpulse im Allgemeinen über 5 kV betragen, beispielsweise im Bereich von 10 bis 40 kV liegen. Günstigerweise kann die Höhe der Spannungsimpulse am Stoßspannungsgenerator eingestellt werden. Vorteilhafterweise wird vom Stoßspannungsgenerator zumindest ein einstellbarer Bereich von 2 kV bis 30 kV abgedeckt, wobei der abgedeckte Bereich auch größer sein kann.

Eine den Kabelfehler ortende Person 4 führt eine mobile Feinortungseinrichtung 5 mit sich. Diese umfasst im gezeigten Ausführungsbeispiel zwei getrennte Geräte, nämlich eine Erfassungseinheit 6 und eine Anzeigeeinheit 7. Die Datenübertragung zwischen der Erfassungseinheit 6 und der Anzeigeeinheit 7 erfolgt im Ausführungsbeispiel drahtlos, z.B. mittels Bluetooth, könnte aber auch drahtgebunden erfolgen.

Die Erfassungseinheit 6 weist ein Bodenmikrophon 8 und einen elektromagnetischen Sensor 9 auf. Vom Bodenmikrophon 8 und vom elektromagnetischen Sensor 9 abgegebene Signale werden von einem analogen Schaltkreis erfasst, A/D-gewandelt und einer Mikroprozessoreinheit zugeführt. Der analoge Schaltkreis, der A/D-Wandler und die Mikroprozessoreinheit sind in Fig. 2 schematisch als elektronische Signalverarbeitungseinheit 10 dargestellt. Im Weiteren werden die Daten mittels eines Senders 11 an einen Empfänger 12 der Anzeigeeinheit 7 übertragen. Die empfangenen Daten werden in einer Mikroprozessoreinheit 13 ausgewertet und von der Mikroprozessoreinheit 13 wird eine Anzeige 14 angesteuert. In der Mikroprozessoreinheit 13 sind schematisch ein Mikroprozessor 15 und ein Speicher 16 angedeutet. Die Mikroprozessoreinheit 13 wird im Allgemeinen weitere Bauteile aufweisen, welche in Fig. 2 nicht dargestellt sind.

Im Weiteren weist die Anzeigeeinheit 7 einen mit der Mikroprozessoreinheit 13 verbundenen GPS-Empfänger 17 zum Empfang von GPS-Signalen auf.

Wenn von der Anzeigeeinheit 7 auch Daten an die Erfassungseinheit 6 übertragen werden sollen, was im Allgemeinen zweckmäßig sein wird, so werden der Sender 11 und der Empfänger 12 jeweils als Sende-Empfangseinheit ausgebildet. Im Falle der drahtgebundenen Datenübermittlung könnten der Sender 11 und der Empfänger 12 auch entfallen. Es könnte dann auch nur eine Mikroprozessoreinheit entweder in der Anzeigeeinheit 7 oder in der Erfassungseinheit 6 vorgesehen sein, welche mindestens einen Mikroprozessor 15 und einen Speicher 16 aufweist.

Bei der Anzeigeeinheit kann es sich um ein Smartphone oder ein Tablet handeln. Es kann ein kommerziell erhältliches Smartphone oder Tablet eingesetzt werden, welches entsprechend eingerichtet ist. Die Anzeigeeinheit kann aber auch speziell für diese Anwendung ausgebildet sein.

In einer modifizierten Ausführungsform könnten die Erfassungseinheit 6 und die Anzeigeeinheit 7 auch zu einem gemeinsamen Gerät verbunden sein.

Vom Bodenmikrofon empfangene Signale können an einen Kopfhörer und/oder Lautsprecher ausgegeben werden, sodass der Benutzer ein akustisches Feedback erhält.

Um die Feinortung des Kabelfehlers durchzuführen, werden mit dem Stoßspannungsgenerator 2 sich wiederholende Stoßspannungsimpulse 3 in das Kabel 1 eingespeist. Die Stoßspannungsimpulse 3 führen jeweils zu einem Überschlag an der Fehlerstelle f des Kabels 1, wodurch ein akustisches Signal in Form eines akustischen Impulses 18 erzeugt wird. Dieser akustische Impuls 18 breitet sich in alle Richtungen im das Kabel 1 umgebenden Erdreich 19 aus.

Wenn ein in das Kabel 1 eingespeister Stoßspannungsimpuls 3 den Bereich unterhalb der mobilen Feinortungseinrichtung 5 passiert, so wird das hierdurch hervorgerufene elektromagnetische Signal vom elektromagnetischen Sensor 9 als elektromagnetischer Impuls detektiert. Dieser detektierte elektromagnetische Impuls wird von der Mikroprozessoreinheit 13 als erster Trigger herangezogen, welcher eine Zeitmessung auslöst. Wenn vom Bodenmikrophon 8 der akustische Impuls 18, welcher durch den vom Stoßspannungsimpuls ausgelösten Überschlag hervorgerufen worden ist, empfangen wird und ein entsprechendes Signal an die Mikroprozessoreinheit 13 ausgegeben wird, so wird dies von der Mikroprozessoreinheit 13 als zweites Triggersignal herangezogen, welches die Zeitmessung beendet. Aus der verstrichenen Zeit Δt zwischen dem ersten und dem zweiten Triggersignal wird der Abstand $s_1$ der im Erdreich liegenden tatsächlichen Fehlerstelle f des Kabels 1 von der aktuellen Position $a_1$ der Feinortungseinrichtung 5 bestimmt. Es kann hierbei die Laufzeit des Stoßspannungsimpulses zwischen dem Bereich der aktuellen Position der mobilen Feinortungseinrichtung 5 und der Fehlerstelle f bzw. die Ausbreitungszeit des durch den Stoßspannungsimpuls hervorgerufenen, vom elektromagnetischen Sensor 9 detektierten elektromagnetischen Impulses vernachlässigt werden, da die Ausbreitungsgeschwindigkeit $v_A$ des akustischen Impulses, also die Schallgeschwindigkeit im Erdreich 19, wesentlich geringer ist. Der Abstand $s_1$ bestimmt sich somit zu:

$$s_1 = v_A \cdot \Delta t$$

Diese Bestimmung des Abstands $s_1$ der tatsächlichen Fehlerstelle f des Kabels 1 von der aktuellen Position $a_1$ der mobilen Feinortungseinrichtung 5 ist bekannt und wird auch als "Koinzidenzmethode" bezeichnet.

Die aktuelle Position $a_1$ der mobilen Feinortungseinrichtung 5 wird mittels des GPS-Empfängers 17 der mobilen Feinortungseinrichtung 5 erfasst. Im Speicher 16 der mobilen Feinortungseinrichtung 5 ist zudem der geografische Verlauf des Kabels 1, also dessen Verlegestrecke, gespeichert. Hierzu können vorhandene Geo-Daten für den Kabelverlauf zuvor in den Speicher 16 eingespeichert worden sein, beispielsweise durch Übertragung aus einer GIS-Datenbank. Auch kann der Kabelverlauf vom Benutzer eingegeben worden sein. Sollte der genaue Verlauf des Kabels nicht bekannt sein, müsste dieser zuvor ermittelt werden. Methoden zur Bestimmung des Kabelverlaufs sind, wie bereits erwähnt, bekannt.

Anhand des ermittelten Abstands $s_1$ der tatsächlichen Fehlerstelle f von der aktuellen Position $a_1$ der Feinortungseinrichtung in Verbindung mit der über den GPS-Empfänger ermittelten aktuellen Position $a_1$ der Feinortungseinrichtung und des in der Feinortungseinrichtung 5 gespeicherten Verlaufs des Kabels 1 werden von der Feinortungseinrichtung 5 mögliche präzise Positionen $p_1$ des Kabelfehlers ermittelt. Diese ergeben sich als Schnittpunkte eines Kreises, der den Radius $s_1$ und als Zentrum die aktuelle Position a1 der Feinortungseinrichtung 5 aufweist, mit dem gespeicherten Verlauf des Kabels 1.

Bei der tatsächlichen präzisen Position $p_1$ des Kabelfehlers handelt es sich um die Stelle auf dem Boden 20 vertikal oberhalb der tatsächlichen Fehlerstelle f. Bei der Bestimmung der möglichen präzisen Positionen $p_1$ des Kabelfehlers kann somit gegebenenfalls die Verlegetiefe des Kabels 1, welche bekannt ist oder für die ein üblicher Standardwert herangezogen werden kann, berücksichtigt werden. Für den Radius des Kreises kann dann anstatt $s_1$ der Wert $s_1$' (= Abstand der aktuellen Position $a_1$ der Feinortungseinrichtung 5 von der vertikal oberhalb der tatsächlichen Fehlerstelle f liegenden präzisen Position $p_1$ des Kabelfehlers auf dem Boden 20) herangezogen werden. Der Unterschied zwischen $s_1$ und $s_1$' kann näherungsweise aberauch vernachlässigt werden.

Im Ausführungsbeispiel ergeben sich zwei Schnittpunkte des Kreises mit dem Verlauf des Kabels, also zwei mögliche präzise Positionen $p_1$ des Kabelfehlers. Es könnten sich auch mehr als zwei Schnittpunkte und somit mehr als zwei mögliche präzise Positionen $p_1$ des Kabelfehlers ergeben, insbesondere wenn das Kabel 1 eine Verzweigung aufweist oder S- oder U-förmig verläuft.

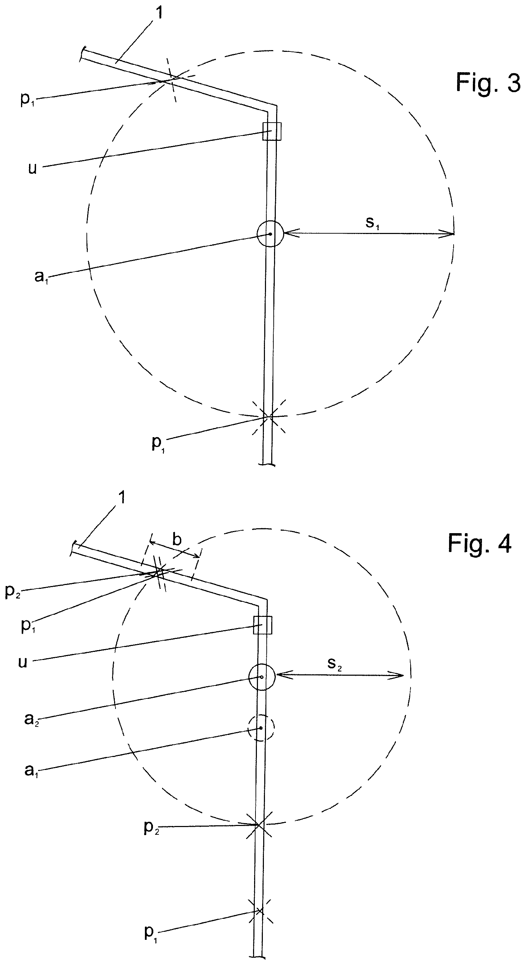

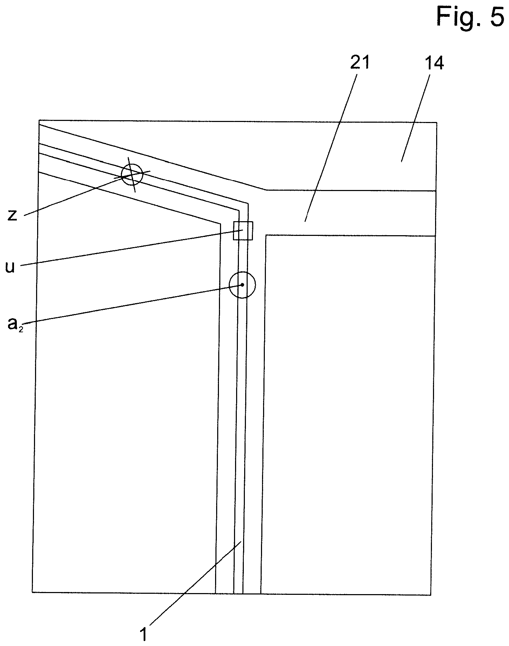

Durch mindestens eine weitere Messung mit einer geänderten aktuellen Position $a_2$ der mobilen Feinortungseinrichtung 5 kann eine eindeutige präzise Position des Kabelfehlers, also eine einzige mögliche präzise Position des Kabelfehlers bestimmt werden. Wenn nach der ersten Messung die Position der mobilen Feinortungseinrichtung 5 geändert wird, so ändert sich auch der ermittelte Abstand zwischen der nunmehrigen aktuellen Position $a_2$ der mobilen Feinortungseinrichtung 5 und der Fehlerstelle f. Dieser geänderte Abstand ist in Fig. 4 als $s_2$ eingetragen (es könnte wiederum stattdessen unter Berücksichtigung der Verlegetiefe des Kabels 1 ein korrigierter Abstand $s_2$' herangezogen werden). Der Kreis mit der nunmehrigen aktuellen Position $a_2$ der mobilen Feinortungseinrichtung 5 als Zentrum und $s_2$ (bzw. $s_2$') als Radius bildet wiederum, im Ausführungsbeispiel zwei, Schnittpunkte mit dem Verlauf des Kabels 1, welche mögliche präzise Positionen p2 des Kabelfehlers darstellen. Die aus der ersten Messung erhaltenen möglichen präzisen Positionen $p_1$ des Kabelfehlers sind in Fig. 4 durch strichlierte Kreuze dargestellt. Im Bereich der tatsächlichen Fehlerstelle f stimmen die aus den verschiedenen Messungen erhaltenen möglichen präzisen Positionen $p_1$, $p_2$ des Kabelfehlers weitgehend überein, abgesehen von Messfehlern (beispielsweise aufgrund einer nicht erfolgten oder nicht exakt erfolgten Berücksichtigung der Verlegetiefe des Kabels 1). Dort, wo also mögliche präzise Positionen $p_1$, $p_2$ des Kabelfehlers, die in zwei oder mehr Messungen erhalten worden sind, innerhalb eines Toleranzbereiches b liegen, wird ein Zielort für den Kabelfehler festgesetzt und die anderen möglichen präzisen Positionen $p_1$, $p_2$, welche einen größeren Abstand als b voneinander aufweisen, werden verworfen. Dieser Zielort z wird auf der Anzeige 14 der mobilen Feinortungseinrichtung 5 dargestellt, und zwar auf einer Karte, welche zuvor auf der Feinortungseinrichtung 5 gespeichert worden ist. Die zuvor auf der Feinortungseinrichtung gespeicherte Karte umfasst also jedenfalls eine Umgebung der im Vorortungsverfahren ermittelten ungefähren Position u des Kabelfehlers (wobei die Karte vorzugsweise zumindest einen Bereich von 500 m um die in der Vorortung ermittelte ungefähre Position u des Kabelfehlers enthält). Die Karte kann von vorneherein in der Feinortungseinrichtung 5 gespeichert sein oder auch für den jeweiligen Anwendungsfall aus dem Internet heruntergeladen worden sein. Wie aus Fig. 5 ersichtlich, sind in der Karte Straßenverläufe 21 dargestellt. Außerdem ist der Verlauf des Kabels 1 dargestellt. Zudem ist die aktuelle Position $a_1$ der mobilen Feinortungseinrichtung 5 dargestellt. Vorzugsweise ist auch die in der Vorortung ermittelte ungefähre Position u des Kabelfehlers dargestellt.

Bei dem in der Karte dargestellten Zielort z kann es sich um die in der letzten durchgeführten Messung ermittelte mögliche präzise Position $p_2$ des Kabelfehlers handeln, welche innerhalb des Toleranzbereichs b liegt. Auch die aus mehreren vorhergehenden Messungen erhaltenen möglichen präzisen Positionen $p_1$, $p_2$ des Kabelfehlers, welche innerhalb des Toleranzbereichs b liegen, können als (durch Messfehler minimal voneinander abweichende) Zielorte z dargestellt werden. Stattdessen könnte beispielsweise als Zielort z ein Mittelwert von innerhalb des Toleranzbereichs b liegenden möglichen präzisen Positionen $p_1$, $p_2$ des Kabelfehlers, die in zwei oder mehr vorausgehenden Messungen ermittelt worden sind, dargestellt werden.

Beim Toleranzbereich b kann es sich um einen vorgegebenen maximalen Abstand zwischen den in den einzelnen Messungen erhaltenen präzisen Positionen $p_1$, $p_2$ des Kabelfehlers handeln. Der Toleranzbereich b kann auch vom ermittelten Abstand s zwischen der aktuellen Position $a_1$ der Feinortungseinrichtung 5 und der tatsächlichen Fehlerstelle f des Kabels 1 abhängen, wobei der Toleranzbereich b bei einem geringeren Abstand s günstigerweise kleiner gewählt wird als bei einem größeren Abstand s.

Nachdem der Zielort z auf der Anzeige 7 in der Karte dargestellt ist, kann sich die die Feinortung durchführende Person 4 direkt an den Zielort z begeben. Dort kann die Lokalisierung der tatsächlichen Fehlerstelle noch durch Pegelmessungen der Lautstärke verifiziert werden.

Durch das erfindungsgemäße Verfahren wird somit für den Nutzer eine sehr zeitsparende und zuverlässige Feinortung ermöglicht.

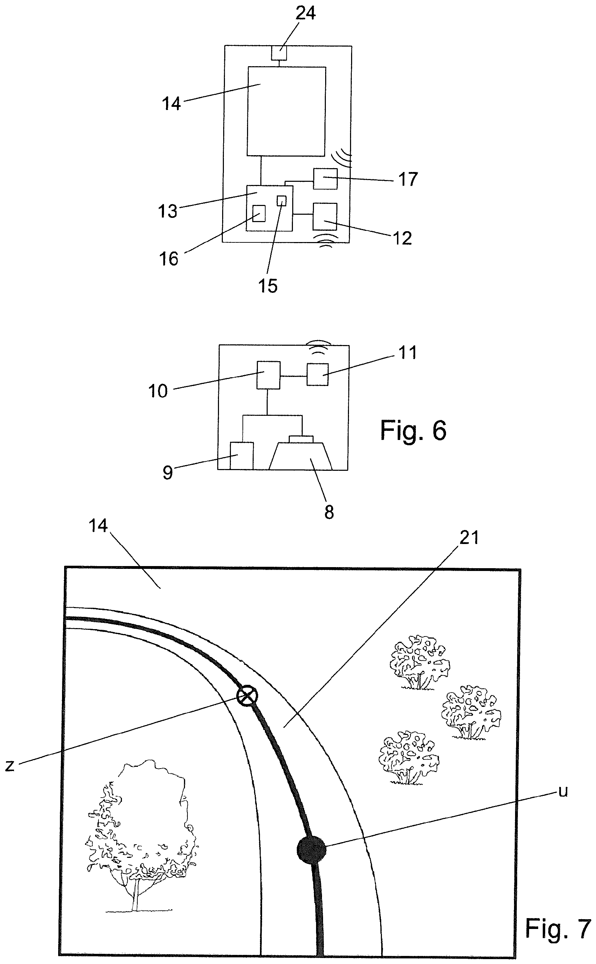

Eine modifizierte Ausführungsform der Erfindung wird im Folgenden anhand der Fig. 6 und 7 erläutert. Abgesehen von den im Folgenden beschriebenen Unterschieden entspricht die modifizierte Ausbildungsform der zuvor beschriebenen Ausführungsform und deren Beschreibung ist entsprechend anwendbar, zusammen mit den beschriebenen möglichen Modifikationen.

Der Unterschied zur zuvor beschriebenen Ausführungsform besteht darin, dass zur Darstellung des mindestens einen Zielorts z auf der Anzeige 14 der mobilen Feinortungseinrichtung 5 der Benutzer mit einer Kamera 24 der mobilen Feinortungseinrichtung 5 ein Bild (Foto) der Umgebung der ungefähren Position u des Kabelfehlers aufnimmt und der zumindest eine Zielort z in diesem Bild dargestellt wird, vgl. Fig. 7. Der mindestens eine, vorzugsweise genau eine, Zielort z für die tatsächliche Fehlerstelle wird also in das von der Kamera der Feinortungseinrichtung aufgenommene reelle Bild eingeblendet. Sollte sich der Zielort z (oder mindestens einer der Zielorte z) außerhalb des von der Kamera aufgenommenen Bildes befinden, so wird dies dem Benutzer entsprechend signalisiert.

Diese modifizierte Ausführungsform der Erfindung kann auch mit der zuvor beschriebenen Ausführungsform der Erfindung kombiniert werden, wobei für den Benutzer auswählbar ist, ob in der Anzeige die Karte oder ein von der Kamera aufgenommenes Bild dargestellt wird.

Unterschiedliche weitere Modifikationen der Erfindung sind denkbar und möglich. So könnten beispielsweise die zuvor durch die Mikroprozessoreinheit 13 beschriebenen Auswertungen auch ganz oder teilweise in der Mikroprozessoreinheit der Erfassungseinheit 6 durchgeführt werden.

Legende zu den Hinweisziffern:

| | |
|---|---|
| 1 | Kabel |
| 2 | Stoßspannungsgenerator |
| 3 | Stoßspannungsimpuls |
| 4 | Person |
| 5 | mobile Feinortungseinrichtung |
| 6 | Erfassungseinheit |
| 7 | Anzeigeeinheit |
| 8 | Bodenmikrophon |
| 9 | elektromagnetischer Sensor |
| 10 | elektronische Signalverarbeitungseinheit |
| 11 | Sender |
| 12 | Empfänger |
| 13 | Mikroprozessoreinheit |
| 14 | Anzeige |
| 15 | Mikroprozessor |
| 16 | Speicher |
| 17 | GPS-Empfänger |
| 18 | akustischer Impuls |
| 19 | Erdreich |
| 20 | Boden |
| 21 | Straßenverlauf |
| 22 | elektromagnetischer Impuls |
| 23 | Kamera |
| f | Fehlerstelle des Kabels |
| u | ungefähre Position des Kabelfehlers |
| $a_1$, $a_2$ | aktuelle Position der Feinortungseinrichtung |
| $p_1$, $p_2$ | mögliche präzise Position des Kabelfehlers |
| b | Toleranzbereich |
| z | Zielort |

**Patentansprüche**

1. Verfahren zur Feinortung eines Kabelfehlers eines erdverlegten Kabels (1) zur Übertragung von elektrischer Energie, bei welchem mit einer mobilen Feinortungseinrichtung (5) auf der Basis einer zuvor durch eine Vorortung ermittelten ungefähren Position (u) des Kabelfehlers eine präzise Position des Kabelfehlers ermittelt wird, wobei mittels der mobilen Feinortungseinrichtung (5) ein Abstand ($s_1$, $s_2$) der Fehlerstelle (f) des Kabels (1) von einer aktuellen Position (a) der mobilen Feinortungseinrichtung (5) bestimmt wird, wobei zur Bestimmung des Abstands ($s_1$, $s_2$) der Fehlerstelle (f) von der aktuellen Position ($a_1$, $a_2$) der mobilen Feinortungseinrichtung (5) Stoßspannungsimpulse (3) in das Kabel (1) eingespeist werden und von der mobilen Feinortungseinrichtung (5) die Zeitdifferenz ($\Delta t$) zwischen einem, von einem der Stoßspannungsimpulse hervorgerufenen, elektromagnetischen Impuls (22), der mittels eines elektromagnetischen Sensors (9) der Feinortungseinrichtung (5) detektiert wird, und einem durch einen von diesem Stoßspannungsimpuls ausgelösten Überschlag beim Kabelfehler hervorgerufenen akustischen Impuls (18), der mittels eines Bodenmikrophons (8) detektiert wird, gemessen wird und von der Feinortungseinrichtung (5) aus dieser Zeitdifferenz ($\Delta t$) der Abstand ($s_1$, $s_2$) der Fehlerstelle (f) von der aktuellen Position ($a_1$, $a_2$) der mobilen Feinortungseinrichtung (5) bestimmt wird, **dadurch gekennzeichnet, dass** an zumindest zwei unterschiedlichen aktuellen Positionen ($a_1$, $a_2$) der Feinortungseinrichtung (5) von der mobilen Feinortungseinrichtung (5) mittels eines GPS-Empfängers (17) der Feinortungseinrichtung (5) die jeweilige aktuelle Position ($a_1$, $a_2$) der Feinortungseinrichtung (5) erfasst wird und der jeweilige Abstand ($s_1$, $s_2$) der mobilen Feinortungseinrichtung (5) von der Fehlerstelle (f) bestimmt wird und an den jeweiligen aktuellen Positionen ($a_1$, $a_2$) der Feinortungseinrichtung (5) von der Feinortungseinrichtung (5) anhand der jeweils erfassten aktuellen Position ($a_1$, $a_2$) der Feinortungseinrichtung (5), des jeweils ermittelten Abstands ($s_1$, $s_2$) der Fehlerstelle (f) von der aktuellen Position ($a_1$, $a_2$) der Feinortungseinrichtung (5) sowie des in der Feinortungseinrichtung (5) gespeicherten Verlaufs des Kabels (1) die möglichen präzisen Positionen ($p_1$, $p_2$) des Kabelfehlers bestimmt werden und festgestellt wird, welche der so bestimmten möglichen präzisen Positionen ($p_1$, $p_2$) des Kabelfehlers innerhalb eines Toleranzbereichs (b) am gleichen Ort liegen, und auf einer Anzeige (14) der Feinortungseinrichtung (5) in einer in der Feinortungseinrichtung (5) gespeicherten Karte der Umgebung der ungefähren Position (u) des Kabelfehlers oder in einem von einer Kamera (24) der mobilen Feinortungseinrichtung (5) aufgenommenen Bild innerhalb des Toleranzbereichs (b) zumindest ein Zielort (z) für die präzise Position des Kabelfehlers angezeigt wird.

2. Verfahren nach Anspruch 1, **dadurch gekennzeichnet, dass** von den bei der letzten der durchgeführten Messungen ermittelten möglichen präzisen Positionen ($p_2$) des Kabelfehlers diejenige, die innerhalb des Toleranzbereichs (b) liegt, in der Karte oder im Bild als Zielort (z) dargestellt wird.

3. Verfahren nach Anspruch 2, **dadurch gekennzeichnet, dass** zusätzlich von den bei mindestens einer der vor der letzten Messung durchgeführten Messungen ermittelten möglichen präzisen Positionen ($p_1$) des Kabelfehlers diejenige(n), die innerhalb des Toleranzbereichs (b) liegt bzw. liegen, in der Karte oder im Bild als Zielort(e) dargestellt wird bzw. werden.

4. Verfahren nach Anspruch 1, **dadurch gekennzeichnet, dass** ein Mittelwert von mindestens zwei in den durchgeführten Messungen ermittelten möglichen präzisen Positionen ($p_1$, $p_2$) des Kabelfehlers, die innerhalb des Toleranzbereichs (b) liegen, in der Karte oder im Bild als Zielort (z) dargestellt wird.

5. Verfahren nach einem der Ansprüche 1 bis 4, **dadurch gekennzeichnet, dass** eine Datenübertragung zwischen einer das Bodenmikrophon (8) und den elektromagnetischen Sensor (9) aufweisenden Erfassungseinheit (6) der mobilen Feinortungseinrichtung (5) und einer die Anzeige (14) aufweisenden Anzeigeeinheit (7) der mobilen Feinortungseinrichtung (5) drahtlos erfolgt.

## Claims

1. Method for pinpointing a cable fault in a buried cable (1) for transmitting electrical energy, in which a precise position of the cable fault is ascertained using a mobile pinpointing device (5) on the basis of an approximate position (u) of the cable fault ascertained previously by a pre-locating operation, a distance ($s_1$, $s_2$) to the fault location (f) in the cable (1) from a current position (a) of the mobile pinpointing device (5) being determined by means of the mobile pinpointing device (5), surge voltage pulses (3) being input into the cable (1) to determine the distance ($s_1$, $s_2$) to the fault location (f) from the current position ($a_1$, $a_2$) of the mobile pinpointing device (5), and the mobile pinpointing device (5) measuring the time difference ($\Delta t$) between an electromagnetic pulse (22), caused by one of the surge voltage pulses and detected by means of an electromagnetic sensor (9) of the pinpointing device (5), and an acoustic pulse (18), caused at the cable fault by a flashover triggered by said surge voltage pulse and detected by means of a ground microphone (8), and the pinpointing device (5) determining from said time difference ($\Delta t$) the distance ($s_1$, $s_2$) to the fault location (f) from the current position ($a_1$, $a_2$) of the mobile pinpointing device (5), **characterised in that**, at least at two

different current positions ($a_1$, $a_2$) of the pinpointing device (5), the respective current position ($a_1$, $a_2$) of the pinpointing device (5) is recorded by the mobile pinpointing device (5) using a GPS receiver (17) of the pinpointing device (5), and the particular distance ($s_1$, $s_2$) to the mobile pinpointing device (5) from the fault location (f) is determined, and, at each current position ($a_1$, $a_2$) of the pinpointing device (5), the possible precise positions ($p_1$, $p_2$) of the cable fault are determined by the pinpointing device (5) on the basis of each recorded current position ($a_1$, $a_2$) of the pinpointing device (5), each ascertained distance ($s_1$, $s_2$) to the fault location (f) from the current position ($a_1$, $a_2$) of the pinpointing device (5) and the course of the cable (1) stored in the pinpointing device (5), and it is established which of the thus determined possible precise positions ($p_1$, $p_2$) of the cable fault are found at the same location within a tolerance range (b), and at least one destination (z) for the precise position of the cable fault is displayed on a display (14) of the pinpointing device (5) on a map, stored in the pinpointing device (5), of the surroundings of the approximate position (u) of the cable fault or in an image taken by a camera (24) of the mobile pinpointing device (5).

2. Method according to claim 1, **characterised in that**, out of the possible precise positions ($p_2$) of the cable fault as ascertained in the last of the measurements taken, the possible precise position that is found within the tolerance range (b) is shown on the map or in the image as the destination (z).

3. Method according to claim 2, **characterised in that**, in addition, out of the possible precise positions ($p_1$) of the cable fault as ascertained in at least one of the measurements taken before the last measurement, the possible precise position(s) that is/are found within the tolerance range (b) is/are shown on the map or in the image as the destination(s).

4. Method according to claim 1, **characterised in that** an average value of at least two possible precise positions ($p_1$, $p_2$) of the cable fault, as ascertained in the measurements taken, that are found within the tolerance range (b) is shown on the map or in the image as the destination (z).

5. Method according to any of claims 1 to 4, **characterised in that** data is transmitted wirelessly between a recording unit (6) of the mobile pinpointing device (5), said recording unit comprising the ground microphone (8) and the electromagnetic sensor (9), and a display unit (7) of the mobile pinpointing device (5), said display unit comprising the display (14).

## Revendications

1. Procédé de localisation précise d'un défaut de câble d'un câble enterré (1) servant à la transmission d'énergie électrique, procédé dans lequel une position précise du défaut de câble est déterminée à l'aide d'un dispositif mobile de localisation précise (5) sur la base d'une position approximative (u) du défaut de câble, déterminée au préalable par une prélocalisation, une distance ($s_1$, $s_2$) de l'emplacement de défaut (f) du câble (1) par rapport à une position actuelle (a) du dispositif mobile de localisation précise (5) étant déterminée au moyen du dispositif mobile de localisation précise (5), des impulsions de tension de choc (3) étant injectées dans le câble (1) pour déterminer la distance ($s_1$, $s_2$) de l'emplacement de défaut (f) par rapport à la position actuelle ($a_1$, $a_2$) du dispositif mobile de localisation précise (5), et la différence temporelle ($\Delta$t) entre une impulsion électromagnétique (22) qui est provoquée par l'une des impulsions de tension de choc et qui est détectée au moyen d'un capteur électromagnétique (9) du dispositif de localisation précise (5), et une impulsion acoustique (18) qui est provoquée par une décharge disruptive déclenchée par cette impulsion de tension de choc au niveau du défaut de câble et qui est détectée au moyen d'un microphone de sol (8) étant déterminée par le dispositif mobile de localisation précise (5), et la distance ($s_1$, $s_2$) de l'emplacement de défaut (f) par rapport à la position actuelle ($a_1$, $a_2$) du dispositif mobile de localisation précise (5) étant déterminée par le dispositif de localisation précise (5) à partir de cette différence temporelle ($\Delta$t), **caractérisé en ce qu'**en au moins deux positions actuelles ($a_1$, $a_2$) différentes du dispositif de localisation précise (5), on détermine la position actuelle respective ($a_1$, $a_2$) du dispositif de localisation précise (5) au moyen du dispositif de localisation précise mobile (5) à l'aide d'un récepteur GPS (17) du dispositif de localisation précise (5), et on détermine la distance respective ($s_1$, $s_2$) du dispositif mobile de localisation précise (5) par rapport à l'emplacement de défaut (f), et on détermine les positions précises possibles ($p_1$, $p_2$) du défaut de câble en ces positions actuelles respectives ($a_1$, $a_2$) du dispositif de localisation précise (5) au moyen du dispositif de localisation précise (5) à l'aide de la position actuelle respectivement détectée ($a_1$, $a_2$) du dispositif de localisation précise (5), de la distance respectivement déterminée ($s_1$, $s_2$) de l'emplacement de défaut (f) par rapport à la position actuelle ($a_1$, $a_2$) du dispositif de localisation précise (5) ainsi que du tracé du câble (1) enregistré dans le dispositif de localisation précise (5), et on détermine lesquelles des positions précises possibles ($p_1$, $p_2$) déterminées du défaut de câble sont situées au même endroit à l'intérieur d'une plage de tolérance (b), et on indique au moins un lieu cible (z) pour la position précise du défaut de câble sur un affichage (14) du dispositif de localisation précise (5), sur une carte des environs de la position approximative (u) du défaut de câble mémorisée dans le dispositif de localisation précise (5) ou sur une image prise par une caméra (24) du dispositif mobile de localisation précise (5), à l'intérieur de la plage de tolérance (b).

2. Procédé selon la revendication 1, **caractérisé en ce que,** parmi les positions précises possibles ($p_2$) du défaut de câble déterminées lors de la dernière des mesures effectuées, on représente en tant que lieu cible (z) sur la carte ou sur l'image celle qui est située à l'intérieur de la plage de tolérance (b).

3. Procédé selon la revendication 2, **caractérisé en ce que,** en plus des positions précises possibles ($p_1$) du défaut de câble déterminées lors d'au moins l'une des mesures effectuées avant la dernière mesure, on représente en tant que lieu(x) cible sur la carte ou sur l'image celle(s) qui se trouve(nt) à l'intérieur de la plage de tolérance (b).

4. Procédé selon la revendication 1, **caractérisé en ce qu'**on représente en tant que lieu cible (z) sur la carte ou sur l'image une valeur moyenne d'au moins deux positions précises possibles ($p_1$, $p_2$) du défaut de câble déterminées au cours des mesures effectuées et situées à l'intérieur de la plage de tolérance (b).

5. Procédé selon l'une des revendications 1 à 4, **caractérisé en ce qu'**une transmission de données entre une unité d'acquisition (6) du dispositif mobile de localisation précise (5), équipée du microphone au sol (8) et du capteur électromagnétique (9), et une unité d'affichage (7) du dispositif mobile de localisation précise (5), équipée de l'affichage (14), s'effectue sans fil.

Fig. 1

Fig. 2

Fig. 3

Fig. 4

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2405279 A2
- CN 105676074 A
- DE 102010051213 A1